# EUROPEAN PATENT APPLICATION

(11) **EP 0 843 434 A2**
(43) Date of publication of application: **20.05.1998**
(21) Application number: 97500164.5
(22) Date of filing: 01.10.1997
(51) Int. Cl.: H04J 3/16, H04J 3/14, H04J 3/04

(54) **Line interface circuit for wideband transmission**

(30) Priority: 19.11.1996 ES 9602435
(71) Applicant: TELEFONICA DE ESPANA, S.A., 28013 Madrid (ES)
(72) Inventor: Solana De Quesada, Juan Ignacio, 28020 Madrid (ES); Gonzalez Torres, José, 28020 Madrid (ES)
(74) Representative: Sanchez del Campo Gonzalez de Ubierna, Ramon

(57) **Abstract**

Line interface circuit for wideband, consisting of a transmission module and a reception module, the transmission module being formed by a converter block of parallel - series format (1), receiving data from a multiplexing block (14), and aleatorizing block (15), and a generation block of transmission clock (12), the parity generating block (13), the aleatorizing block (15), and the multiplexing block (14) being interconnected, while the reception module is constituted starting from a converter block of series to parallel format (33), receiving data from a reception clock generation block (34) and sending data to a demultiplexing block (36) and a parity verification block (32), as well as to a desaleatorizing block (37) connected to the demultiplexing block (36).

## Description

### BACKGROUND OF THE INVENTION

The present specification refers to a request for an application for a patent of invention concerning a line interface circuit for wideband, the evident purpose of which is to be used in equipment of the digital network of integrated services of wideband (DNIS-WB), or for equipment of the synchronous digital hierarchy (SDH), performing a conversion of series-parallel format and vice versa, for rates up to 622 Mbs, and the completion function of section of regeneration and synchronous multiplexing up to four inflows, including the detection - of the alignment of frame, the generation and the checking of the parity of section of regeneration and the aleatorizing and dealeatorizing of line.

### FIELD OF THE INVENTION

The present invention will find application in the field of telecommunications, and, in a most definite way, in systems of transport and switching of the synchronous digital hierarchy (SDH), and the digital network of integrated services of wideband (DNIS-WB).

### RELATED ART

It is well known the existence in the market of commercial products performing the function of conversion of a series to parallel format and vice versa, as well as the possibility, by means of discreet components, of performing functions of completion of section of regeneration and synchronous multiplexing for interfaces of binary rates of high speed.

So, the performance of the above mentioned functions requires a complex circuitry, very bulky and having a high consumption of power.

The line interface integrated circuit of the inven tion solves these problems upon introducing a new architecture performing these functions with reduced complexity in the circuitry, small size, and a reduced consumption of power, which rebounds vey positively on the cost of transport and switching equipment of the digital network of integrated services of wideband (DNIS-WB) and synchronous digital hierarchy (SDH).

### SUMMARY OF THE INVENTION

The line interface circuit for wideband as proposed by the invention, constitutes, per se, an evident novelty within its application field, since, according to its characteristics, it is possible to have a new solution for the line interface circuits of wideband, which are used in the equipment of the terminal section (center wherein the signal is multiplexed/demultiplexed and regenerated) of the network of integrated services of wideband (DNIS-WB), or the synchronous digital hierarchy (SDH).

In a most definite way, the line interface circuit for wideband of the invention, converts a parallel format into a series format, and vice versa, multiplexing and demultiplexing several flows of synchronous frames in a unique series flow, suitable for being transported in optical fiber links.

The invention presents two modules: one transmission module and one receipt module, the transmission module performing a synchronous multiplexing, a parity generation of regeneration section, a line and terminal aleatorizing and a conversion of parallel to series format.

The transmission module is basically constituted by the following blocks, namely:
- Parity generating block.
- Aleatorizing block.
- Generating block of the transmission clock.
- Multiplexing block.
- Converter block of parallel/series format.

The generating block of parity computes the regeneration section parity on all the bytes of each synchronous frame transmitted after the synchronous multiplexing and the line aleatorizing.

The computed value of the parity of each frame is inserted into the field corresponding to the parity of the regeneration section of the following frame, previously to the line aleatorizing.

The position to be occupied by said field will be determined by a signal, which is a primary input of the device.

The aleatorizing block performs an aleatorizing of terminal and line, and the aleatorizing of terminal is performed independently on each of the inflows synchronously multiplexed, while the aleatorizing of line is performed on the global flow of bytes, after the multiplexing of the inflows.

The purpose of aleatorizing the terminal is to facilitate the interconnection of the invention with other devices having smaller speed capable of using signals with PECL (Positive Emitter Coupled Logic) levels, which, in turn, have constant levels shifted with regard to ECL (Emitter Coupled Logic) levels, as used in this invention for entering data from the inflows.

The sequence generating both steps of aleatorizing is initiated again in each synchronous frame with the starting signal of transmission frame.

A signal will indicate the aleatorizer the byts belonging to the first row of the tare of regeneration - section, which must sustain no aleatorizing process.

The terminal and line aleatorizing may be unable by a signal, which is a primary input of the device.

The generating block of the transmission clock generates and distributes, over the remaining blocks of the transmission module, the clocks derived from the transmission line frequency, which is a primary input of the device, using logical ECL (Emitter Coupled Logic) levels, differential.

The clocks derived are: the transmission byte clock, internally used in the circuit, and the transmission inflow circuit, which is a primary output of the device.

The multiplexing block converts the ensemble of byte flows, from the inflows chosen, into a unique multiplexed flow for transmission.

The number of inflows is chosen by-a combination of signals which are primary inputs of the device.

The byte flows from the chosen inflows are inserted into the device through the corresponding primary inputs.

The synchronous multiplexing is performed by intercalating a byte from the inflow of greater rank with a byte from the inflow of following rank, and so on.

The converter block of parallel-series format - converts the flow of multiplexed byts into a flow of bits series.

The converter block of parallel-series generates the primary outputs of the output transmission clock circuit, and transmission data output, adequately - aligned for being used by the external circuitry, and both signals use the ECL (Emitter Coupled Logic) logical levels, this being the reason for which the corresponding denied signals are also present.

The converter block of parallel-series format performs also a function of remote loop, which is controlled by a primary input of the device.

When the remote loop is activated, both the data and the high speed reception clock are directly connected to the data wires and of the transmission clock wires.

The arrangement of loops is specially useful for performing network tests on the corresponding interfaces.

The reception module performs a synchronous demultiplexing, it checks the parity of the regeneration section, it performs the terminal and line desaleatorizing, and the series to parallel format conversion.

The reception module is basically composed of the following blocks, namely:
- Parity verificating block.
- Desaleatorizing block.
- Generating block of the reception clock.
- Demultiplexing block.
- Converter block of series to parallel format.

The parity verificating block computes the parity of the-regeneration section on the received synchronous frames, et compares them with the parity field of regeneration section received.

The result of the comparison carried out, replaces the own field of parity of regeneration section, and if both parities are alike, the result of-the comparison will be OO'H.

The position of the parity field of regeneration section is identified by means of a signal, which is a primary input of the device.

The desaleatorizing block performs the desaleatorizing of both the termianl and the line.

The desaleatorizing of terminal is performed independently on each of the inflows synchronously demultiplexed, while the desaleatorizing of line is performed on the global flow of byts before their- demultiplexing, and the purpose of the desaleatorizing of terminal is to facilitate the interconnection of the invention - with other devices having smaller speed.

The sequence generating both steps of desaleatorizing is initiated again at each synchronous frame with the starting signal of reception frame, which is a primary input of the device.

This same starting signal of reception frame identifies the bytes belonging to the first row of the tare of synchronous frame regeneration section, which are not to sustain any desaleatorizing process, and both desaleatorizing steps may be unable by means of a signal which is a primary input of the device.

The generating block of the reception clock generates and distributes, over the remaining reception blocks, the clocks derived from the reception line frequency, which is a primary input of the device.using the differential logical ECL (Emitter Coupled Logic) levels, this being the reason for which the corresponding denied signal appears also as input, and the clocks derived are the reception byte clock, and the reception inflow clock, the latter being a primary output of the device.

The demultiplexing block converts the received byte flow into anumber of flows directed to the corresponding inflow, and the number of inflows is chosen by - means of signals which are primary inputs of the device.

The byte flows from the chosen inflows come out the device through the corresponding primary outputs, and the synchronous demultiplexing' is performed by extracting, successively, from the received byte flow, a - byte addressed to the greater rank inflow, followed by other byte of the following rank, and -so on.

The converter block of series to parallel format converts the bit flow series, received at the primary input of high speed data, into a byte flow.

The signal of the primary input of high speed daa uses the differential logical ECL (Emitter Couple Logic) levels, this being the reason for which the deni-signal appears also as a primary input.

For converting the bit flow series into a byte flow it has been provided a machine having two states, which are: HOOKED state, and NON-HOOKED, which are controlled by means of several signals of primary inputs.

At the NON-HOOKED state, the converter block of series to parallel format looks for the appearance of the alignment sequence of synchronous frame.

Once the alignment sequence of synchronous frame - has been found, the converter block of series to parallel format aligns the bytes which it generates, so that the alignment sequence is converted into a pair of bytes, and the machine passes to the HOOKED state.

Starting from that moment, the machine maintains the bytes stage captured with the alignment sequence, and it remains in this state and it waits until receiving a control signal indicating it to perform a new alignment process.

If so, la machine would pass to the NON-HOOKED - state, and the process would de initiate again.

The alignment process can be unenabled by means of a control signal which is a primary input of the device.

If this happens, the converter block of format generates the bytes starting from the bits flow series, in a fully independent way of the detection of the - alignment sequence of the synchronous frame.

The converter block of series to parallel format performes a function of local loop, and the high speed primary output derivates from the wires of high speed transmission data, in accordance with the value of a control signal which is a primary input of the device. The arrangement of loops is useful for carrying out - network tests on the corresponding interfaces.

### BRIEF DESCRIPTION OF THE DRAWINGS

In order to complement this description and to aid to a better understanding of the characteristics of the invention, the appending drawings, which are a part of this specification, show, by way of illustrative and non-limiting example the following figures:
Figure 1 is a block diagram of the transmission module of the line interface circuit for wide band of the invention.
Figure 2 corresponds to the block diagram of the reception module incorporating the invention.

### DETAILED DESCRIPTION OF A PREFERRED EMBODINENT

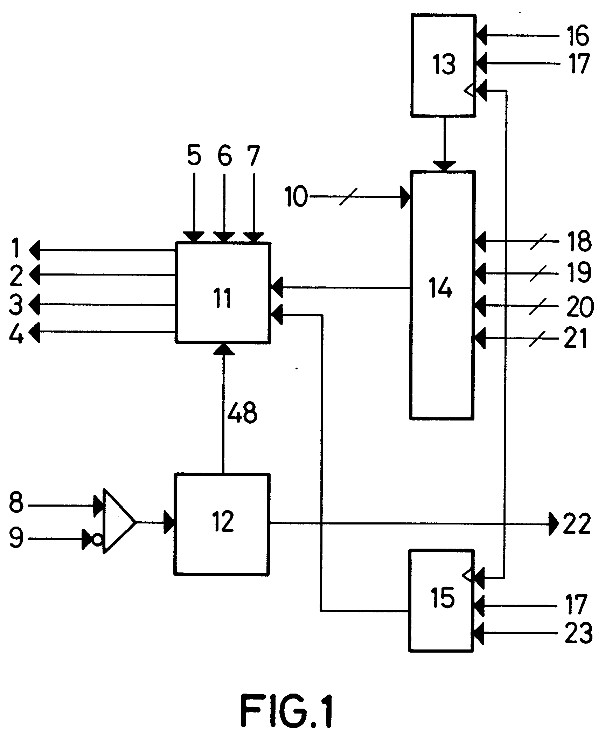

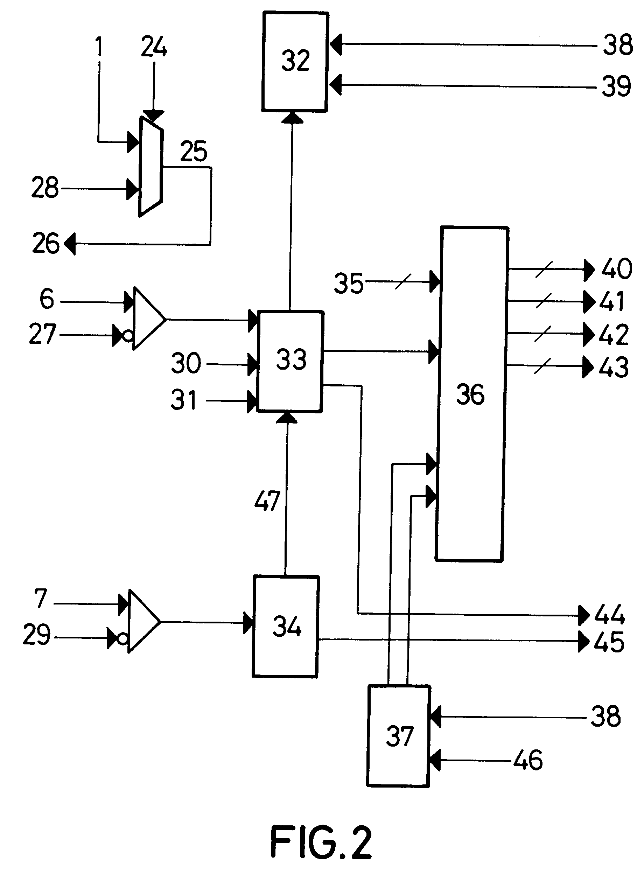

From these figures, it can be seen that the line interface circuit for wideband as proposed by the-invention, is divided into two modules: a transmission module, and a reception module, shown, respectively, in figures 1 and 2.

The transmission module shown in a block diagram of figure 1, performs the synchronous multiplexing, the generation of the parity of regeneration section, the line and terminal aleatorizing, et la conversion of parallel to series format, in accordance with the recommendations G.707, G.708 and G.709 of UIT-T.

The reception module shown in a block diagram of figure 2, performs the synchronous demultiplexing, it checks the parity of the regeneration section (B1), it performs the terminal and line dealeatorizing, and the conversion of series to parallel format, in accordance with the above-mentioned recommendatios G.707, G.708 and G.709 of UIT-T.

Following figure 1, it can be seen that the transmission module of the-line interfaz circuit for wideband of the invention is constituted basically of the following blocks, namely:
- Parity generating block (13).
- Aleatorizing block (15).
- Generating block of the transmission clock (12).
- Multiplexing block (14).
- Converter block of parallel-series format (11).

The parity generating block (13) computes the parity of regeneration section B1 on all the bytes of each synchronous frame transmitted after the synchronous multiplexing and the line aleatorizing.

The value computed of the parity at each frame is inserted in the field corresponding to the-parity of the regeneration section of the following frame, previously to the line aleatorizing.

The position to be occupied by said field is indicated by means of an active pulse at high level of the signal (16), which is a primary input of the device.

The aleatorizing block (15) performs the aleatorizing both of terminal and line, and both steps generate both pseudoaleatory sequences, in accordance with the original polynom g(x)=x⁷+x⁶+1.

The aleatorizing of terminal is performed independently on each of the inflows synchronously multiplexed, while the line aleatorizing is performed on the global flow of bytes, after the inflows have been multiplexed.

The purpose of the terminal aleatorizing is facilitate the interconnection of the invention with other devices of lower speed which can use signals with PECL (Positive Emitter Coupled Logic) levels, with constants speed levels shifted with regard to the ECL (Emitter Coupled Logic) levels, using the inputs (18), (19), (20) and (21).

The aleatorizing of terminal allows the levels of constant to be adapted by means of a simple step condenser, due to the fact that the aleatorized flow of terminal data does not contain information in low frecuences.

The sequence generated by both aleatorizing steps is initiated again at each synchronous frame with a starting signal of transmission frame (17), which is a primary input of the device.

The own signal (17) configured as the starting signal of transmission frame identifies, by means an active pulse at high level, les bytes belonging to the first row of the tare of the regeneration section of each synchronous frame which, in accordance with the recommendation G.708 of UIT-T, do not sustain any aleatorizing - proceess, and both the line and terminal aleatorizing process can be disabled by means of the signal (23), which is a primary input of the device.

The generating block of the transmission clock (12) generates and distributes, over the remaining blocks of the transmission module, the clocks derivated from the frequence of transmission line (8), which is a primary input of the device using the differential logical ECL (Emitter Coupled Logic) levels, this being the reason for which it appears also as input, the denied signal (9).

The clocks derivated are the transmission byte clock (48), which is internally used in the circuit, and the transmission inflow clock (22), which is a primary output of the device.

The multiplexing block (14) converts the ensemble of bytes flows, from the chosen inflows, into a unique multiplexed flow for the transmission.

The number of inflows is chosen by a combination of two signals (10) which are primary inputs of the device, and the combination of signals shows the following, namely:
- Combination 00: there is one inflow.
- Combination 01: there are two inflows.
- Combination 10: there are three inflows.
- Combination 11: there are four inflows.

The byte flows of the chosen inflows are inserted into the device through the primary inputs (21), (20), (19) and (18), the primary input (21) being that of greater rank.

The,synchronous multiplexing is performed by intercalating a byte of the inflow of greater rank avec a byte of the inflow of the following rank, and so on.

The converter block of parallel-series format (11) converts the multiplexed byte flow into a flow of bits series.

The converter block of parallel-series format (11) generates the primary outputs of the circuit of the output transmission clock (3), and that of data transmission (1), adequately aligned for being used by an external circuitry, and both signals use the differential logic ECL (Emitter Coupled Logic) levels, for - which, their corresponding denied signals (4) and (2), respectively, are present.

The converter block of parallel-series format (11) performs also a function of remote loop, which is controlled by a control signal (5), which is a primary input,of the device.

When the remote loop is activated, the data wires (6) and the reception clock at high speed wires (7) are directly connected to the transmission data (1) and transmission clock wires (3).

The arrangement of loops is specially useful for performing network tests on the corresponding interface.

From figure 2, it can be seen that the reception module is constituted basically by the following blocks, namely:
- Parity verification block (32).
- Dealeatorizing block (37).
- Generating blqck of the reception clock (34).
- Demultiplexing block (36).
- Converter block of series to parallel format (33).

The parity verification block (32) computes the parity of regeneration section (B1), on the received synchronous frames, and compares it with the parity field of regeneration section received.

The result of the comparation replaces the own field of parity of regeneration section, and if both parities are equal, the result of the comparison will be OO'H.

La position of the parity field of regeneration section is identified by means of an active pulse at high level of the signal (39), which is a primary input of the device.

The desaleatorizing block (37) performs the desaleatorizing both of terminal and line, and the desaleatorizing of terminal is performed independently on each of the inflows synchroneously demultiplexed, while the desaleatorizing of lines is performed on the global flow of bytes previously to the demultiplexing of them.

Both desaleatorizing steps generate both pseudoaleatory sequences in accordance with the original polynom cited in the description of the invention corresponding to g(x)=x⁷+x⁶+1.

The purpose of the desaleatorizing of terminal is to facilitate the interconnection of the invention with - other devices of lower speed, like the aleatorizing - block (15) of the transmission module.

La sequence generated by both desaleatorizing steps is initiated again at each synchronous frame with starstarting signal of reception frame (38), which is a primary input of the device.

This same signal identifies the bytes belonging to the first row of the tare of regeneration section of each synchronous frame that, in accordance with the recommendation G.708 of UIT, is not to - sustain any desaleatorizing process, and both desaleatorizing steps can be disabled by means of a signal (46), which is a primary input of the device.

The generating block of reception clock (34) generates and distribute, over the remaining reception blocks, the clocks derived from the reception line frequence (7), which is a primary input of the device using the differential logical ECL (Emitter Coupled Logic) levels, this being the reason -for which the corresponding denied signal (29) appears also as input.

The clocks derived are the reception byte clock (47), and the reception inflow clock (45), the latter being a primary output of the device.

The demultiplexing block (36) converts the byte flow received into a number of flows addressed to the relative inflows.

The number of inflows chosen by combining two - signals (35) being primary inputs of the device, the combination of signals showing the following, namely:
- Combination 00: there is one inflow.
- Combination 01: there are two inflows.
- Combination 10: there are three inflows.
- Combination 11: there are four inflows.

So, four inflows can be chosen as a maximum, and the byte flows of the chosen inflows come out-from the device through the corresponding primary outputs (43), (42), (41) and (40), the synchronous demultiplexing being performed by extracting, successively, from the byte flow received, one byte addressed to the inflow of greater rank (43), followed of other one addresaed to that the following rank (42), and so on.

The converter block of series to parallel format (33) converts the flow of series of bits, received with the primary data input at high speed (6), into a flow of bytes.

The signal of data input at high speed (6) uses the differential logical ECL (Emitter Coupled Logic) levels, this being the reason for which the denied signal (27) appears also as primary input.

For converting the flux series of bits into a flow of bytes, it has been provided a two-state machine, said states being: HOOKED and NON-HOOKED, which are controlled by means of two signals (30) and (31), which are primary input of the circuit.

In the state NON-HOOKED, the converter block.of series to parallel format (33) looks for the appearance of the synchrone frame alignment sequence.

Said synchronous frame is 1111011000101000'B.

Once said frequence has been found, the converter block of format alignes the bytes generated by it, so that the previous bit sequence est converted into a pair of bytes F6'H and 28'H, the machine passing to HOOKED state.

Starting from that moment, the machine maintain the byte stage captured with the first alignment sequence, and it remains in that state and it waits so until receiving a control signal indicating it'to perform anew alignment process.

Later alignment sequences detected in the reception flow produce an active pulse at high level at the primary output (44), so that said pulse coincides with the gap of the clock signal (45), immediately subsequent to the byte having a value of 28'H, which presents the second byte of the alignment sequence.

After the pulse in the signal (30), la machine passes to NON-HOOKED state, and the process is initiated again.

The alignment process can be disabled by means of a control signal (31), which is a primary input of the device, and when this happens -control signal at lower level (31), the converter block of format (33) generates les bytes starting from the flow series- of bits in an independent way, of the detection of the alignment sequences of synchronous frame.

Additionally, the converter block of series to parallel format (33) performs a function of local loop, and the primary output at high speed derives, through the multiplexer (25), from the'data wire at high speed of transmission (1), or of the reception line (28), in accordance with the value of the control signal (24), which is a primary input of the device, the arrangement of loops being very useful for performing network tests on the corresponding interfaces.

It is not considered necessary to extend this description for any expert in the art to understand the scope of the invention and the advantages derived from it.

The materials, shape, size and arrangement of its components will be open to variation, -provided that it does not imply any alteration to the essence of the invention.

The terms under which this specification has been described should be always taken in an ample and non-limitative sense.

## Claims

1. A line interface circuit for wideband, of type integrated, and of those constituted by a transmission module, and a reception module, characterized in that the transmission module-is formed by a converter block of'parallel to series format (11), which receives data from a multiplexing block (14),_an aleatorizing block (18), and a generating block of transmission clock (12), the parity generating block (13), the aleatorizing block (15) and the multiplexing block (14) being interconnected, and a receiving module shaped starting from a converter block of series to parallel format (33) receiving data from a generating block of reception - clock (34), and sending data to a demultiplexing block (16), and a parity verification block (32), and of a desaleatorizing block (37), connected to the demultiplexing block (36).

2. A line interface circuit for wideband, according to claim 1, characterized in that the parity generating block (13) computes the parity of regeneration section on the bytes of each frame transmitted after the synchronous multiplexing and the aleatorizing of line

3. A line interface circuit for wideband, according to claim 1, characterized in that the aleatorizing block (15) performs the aleatorizing of terminal independent on each inflow synchroniously multiplexed, while the aleatorizing of line is performed on the global flow of - bytes, after the inflows have been multplexed, both - steps of aleatorizing can be disabled by means of a signal (23), which is a primary input of the device.

4. A line interface circuit for wideband, according to claim 1, characterized in that the generating block of transmission clock (12) generates and distributes over the remaining blocls of transmission module, as derived clocks, a transmission byte clock (48) (internal signal), and the transmission inflow clock (22) (primary output of the device).

5. A line interface circuit for wideband, according to claim 1, characterized in that-the converter block of parallel to series format (11) performs also a function of remote loop, connecting directly the data wires (6) and the reception clock at high speed (7), with the transmission data (1) and transmission clock (3) wires.

6. A line interface circuit for wideband, according to claim 1, characterized in that the desaleatorizing block (37) performs the desaleatorizing of - terminals independent on each of the inflows synchroneously demultiplexed, while the desaleatoring of line is performed on the global flow of bytes before these being demultiplexed, and both desaleatorizing steps can be disabled by means of a signal (46), which is a primary input of the device.

7. A line interface circuit for wideband, according to claim 1, characterized in that the generating block of the reception clock (34) generates and distributes, over the remaining blocks of the reception module, as derived clocks, the reception byte clock (47) (internal signal), and the reception inflow clock (45) (primary output of the device).

8. A line interface circuit for wideband, according to claim 1, characterized in that the converter block of series to parallel format (33) utilizes, for said operation, a two-state machine, controlled by means of several primary input signals, looking for at one of the states the appareance of the alignment sequence of synchronous frame, and, at the other state the maintaining of the captured byte stage, remaining in this state until the corresponding control signal indiques it a new search for alignment; this process can be disabled by means of a primary signal of the device.
